Europäisches Patentamt

European Patent Office

Office européen des brevets

(11) Publication number: **0 081 626**
**B1**

(12) **EUROPEAN PATENT SPECIFICATION**

(45) Date of publication of patent specification: **19.10.88**

(21) Application number: **82105481.4**

(22) Date of filing: **23.06.82**

(51) Int. Cl.⁴: **G 11 C 11/34,** G 11 C 17/00, H 01 L 29/60

(54) **Dual electron injector structure and semiconductor memory device including a dual electron injector structure.**

(30) Priority: **14.12.81 US 330913**

(43) Date of publication of application:
**22.06.83 Bulletin 83/25**

(45) Publication of the grant of the patent:
**19.10.88 Bulletin 88/42**

(84) Designated Contracting States:
**DE FR GB NL SE**

(56) References cited:
**US-A-3 805 130**
**US-A-4 104 675**

**IEEE TRANSACTIONS ON ELECTRON DEVICES, vol. ED-28, no. 9, September 1981, pages 1047-1053, New York, US; D.J. DiMARIA et al.: "Dual-electron-injector-structure electrically alterable read-only-memory modeling studies"**

(73) Proprietor: **International Business Machines Corporation**
**Old Orchard Road**
**Armonk, N.Y. 10504 (US)**

(72) Inventor: **Dimaria, Donelli Joseph**
**Chadeayne Road**
**Ossining New York 10562 (US)**
Inventor: **Dong, David Wah**
**J2 Kissam Road**
**Peekskill New York 10566 (US)**

(74) Representative: **Hobbs, Francis John**
**IBM United Kingdom Limited Intellectual Property Department Hursley Park**
**Winchester Hampshire SO21 2JN (GB)**

(56) References cited:
**JOURNAL OF APPLIED PHYSICS, vol. 52, no. 9, September 1981, pages 5691-5695, New York, US; S.K. LAI et al.: "Reduction of electron trapping in silicon dioxide by high-temperature nitrogen anneal"**

Courier Press, Leamington Spa, England.

## Description

This invention relates to a dual electron injector structure for a non-volatile semiconductor memory device and to a semiconductor memory device including a dual electron injector structure.

In European Patent Application EP—A—0016246 there is described a graded or stepped silicon concentration structure for making a charge storage device wherein injection of holes or electrons from one contact is possible without compensating injection of electrons or holes from the other contact. This is achieved by the inclusion of a charge trapping layer in the thick insulator region adjacent to the silicon semiconducting body. The trapping layer is situated at a distance of approximately 5 nm (50 Å) or more from the Si-insulator interface to prevent trapped carriers from tunnelling from this layer to the Si substrate.

This trapping layer captures and stores either electrons (write operation) or holes (erase operation) with as close to 100% efficiency as possible. An electrically-alterable read-only-memory (EAROM) device using a metal-insulator-semiconductor structures is also described. The structure is fabricated by forming several pyrolytic or CVD $SiO_2$ layers over a relatively thick thermal $SiO_2$ with the pyrolytic $SiO_2$ layers having sequentially increasing excess Si content. The trapping layer is formed by controlled impurity ion-implantation or by diffusion of the impurity into the relatively thick thermal $SiO_2$ layer, or by deposition of the impurity on thermal $SiO_2$ with stoichiometric CVD $SiO_2$ isolating it from the injector region consisting of the Si-rich CVD $SiO_2$ layers. This structure has the limitation of being only a good single carrier electron injector since few holes are injected for the opposite polarity. Consequently, when used in memory devices "erase" times are long (minutes) as compared to write times (milliseconds). See for example the publications to D. J. DiMaria, entitled "Graded or Stepped Energy Band-Gap Insulator MIS Structures (GI-MIS for SI-MIS)" J. Appl. Phys., *50*, 5826 1979 and to D. J. DiMaria et al, entitled "High Current Injection into $SiO_2$ from Si-Rich $SiO_2$ Films and Experimental Applications", J. Appl. Phys. *51*, (5) May 1980, pp. 2722—2735.

An improvement on single electron injector structures is described in European Patent Application EP—A—0034653 and by D. J. DiMaria et al. in IEEE Transactions on Electron Devices, Volume ED-28, no. 9, September 1981, pages 1047 to 1053. The improvement is the addition of a vertically positioned second injector proximate to a trapping layer or floating gate structure in the insulator layer. The dual injector structure so provided can effectively inject holes at the opposite polarity as easily as the injection of electrons by actually ejecting the trapped electrons using the added bottom injector with these being collected by the top gate contact. Thus, when used in a memory device, it provides erase times equivalent to the write times obtained in the single injector memory device. An example of a structure employing the dual injector is an MGOS FET to perform a memory function. More specifically, the MGOS structure employs a charge trapping layer or floating gate near the Si—$SiO_2$ interface of the gate structure in an FET configuration. Layers of Si-rich $SiO_2$—$SiO_2$—Si-rich $SiO_2$ are provided between the control gate and trapping layer or floating gate of the memory device. This insulator stack is referred to as a Dual Electron Injector Structure (DEIS). Writing or erasing is performed by applying a negative and positive voltage, respectively, to the control gate which injects electrons from the top and bottom injector to the floating gate or back to the control gate.

The background operation, fabrication and characteristics of the above described device are discussed in detail in an article entitled, "Electrically-alterable read-only-memory using Si-rich $SiO_2$ injectors and a floating polycrystalline silicon storage layer" by D. J. DiMaria et al, J. Appl. Phys. 52 (7), July 1981, 4825—4842. In this article, attention is particularly directed to the fact that the DEIS (Dual Electron Injector Structure) EAROM experiences a phenomenon called threshold collapse after a device has been subjected to writing and erasing functions between $10^4$ and $10^6$ cycles. This is due to electronic charge trapping in the $SiO_2$ insulator disposed between the Si-rich $SiO_2$ layers. To the extent that the prior art device experiences threshold collapse at between $10^4$ and $10^6$ cycles, the DEIS EAROM cannot be extended to a pure Non-Volatile Random-Access-Memory (NVRAM).

The present invention provides a dual electron injector structure comprising first, second and third regions, the first region being disposed on top of the second region and the second region on top of the third region, the second region having a higher resistance than that of the first and third regions and the first and third regions consisting of a mixture of insulating and conductive materials, the structure being characterised in that the second region is slightly conductive and consists of a mixture of insulating and conductive materials such that it is conductive only at high electric fields and highly blocking at low electric fields.

This invention can lead to the production of a pure Non-Volatile Random-Access-Memory (NVRAM) device which is not subject to threshold collapse for more than $10^6$ cycles.

How the invention can be carried out will now be described by way of example, with reference to the accompanying drawings, in which:—

Fig. 1 represents a non-volatile n-channel FET memory device including a dual electron injector structure according to the invention;

Fig. 2 is a graph showing the variations in threshold voltage with the number of write and erase cycles for three different values of resistivity of the conductive insulator disposed between injectors;

Fig. 3 is a graph similar to that shown in Fig. 2 which shows that, for high values of $R_o$ (where $R_o$

is the ratio of $N_2O$ to $SiH_4$ in the gas phase in the CVD reactor) representing pure $SiO_2$, total threshold collapse occurs before $10^3$ cycles, while, for lower values of $R_o$, threshold collapse does not occur for cycles in excess of $10^7$; and

Fig. 4 is a graph of threshold voltage variation with time (secs) for insulators having $R_o$ values of 30, 40, 50 and 200.

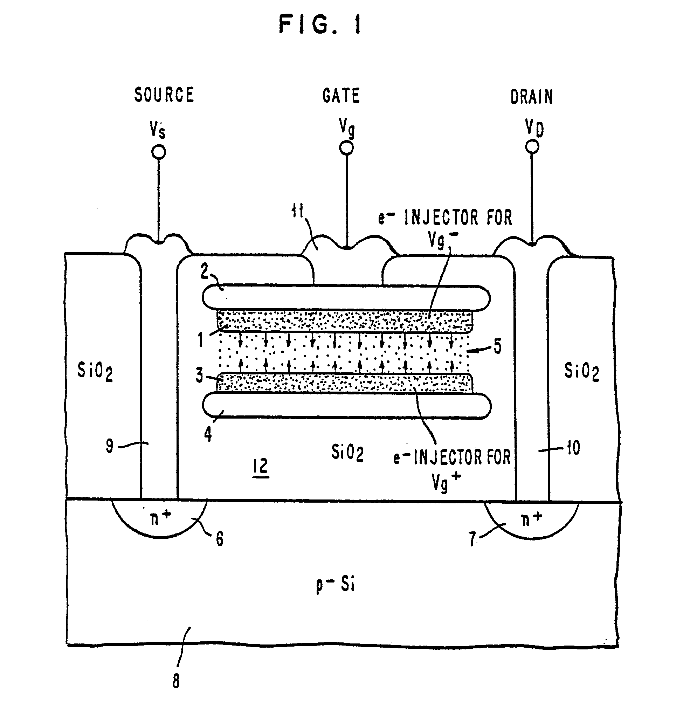

Referring to Fig. 1, a dual electron injector structure of a non-volatile, n-channel, FET memory device is composed of a Si-rich $SiO_2$ region 1 which is contiguous with and beneath a polysilicon or metal gate region 2, and a second Si-rich $SiO_2$ region 3 contiguous with and atop a floating gate region 4 which may be made of polysilicon or metal. Regions 1, 3 are separated by means of an $SiO_2$ region 5 which has been rendered slightly conductive by the addition of 1—6% Si to drain off trapped charge in this region. The intervening $SiO_2$ region 5 is conductive at the high electric fields used for writing and erasing the device and highly blocking to the motion of charge between gates at low electric fields used for reading or storage. As a result, the ability to cycle the device of Fig. 1 between written and erased states is improved to greater than $10^8$ cycles. Si-rich $SiO_2$ area 5 is provided by the chemical vapour deposition of $SiO_2$ which is off stoichiometry to the extent it contains about 1—6% excess atomic Si.

Si-rich $SiO_2$ regions 1, 3 have graded or stepped concentrations of Si which are prepared by hye chemical vapour deposition of a plurality of $SiO_2$ layers having varying concentrations of Si. The number of layers, the thickness of each layer, and the concentration of excess Si in each successive layer making up regions 1, 3 is a matter of design choice. Increasing the Si content of the Si-rich $SiO_2$ regions 1, 3 enhances the electron injection capability, thereby decreasing write and/or erase voltages and/or times. A preferred Si content of regions 1, 3 is from about 46 to about 60 atomic per cent Si. The operation of the injectors is not very sensitive to injector thickness (from 10 nm (100 Å) to 100 nm (1000 Å)) or the exact Si content to within a few percent because the interfaces of the lower resistance Si-rich $SiO_2$ layers 1, 3 with the higher resistance layer 5 control the electron injection phenomenon.

In Fig. 1, first and second $n^+$ regions 6, 7, respectively are shown formed in a p- silicon substrate 8. Voltages $V_s$, $V_D$ and $V_g$, otherwise identified in Fig. 1 by the captions SOURCE, DRAIN and GATE, respectively, are connected via metallization 9, 10 and 11, respectively, to $n^+$ region 6, $n^+$ region 7 and polysilicon gate 2.

The FET structure shown in Fig. 1 may be fabricated using a self-aligned, double poly-Si process. After defining thick field oxide regions (not shown), the exposed substrate portion of the device of Fig. 1 is subjected to a thermal oxidation step which forms a layer of $SiO_2$ in the thickness range from 5—100 nm (50—1000 Å) on the surface of the substrate. The latter is a 0.5 Ωcm (100), p-type, signal crystal silicon substrate. Next, a 200

nm (2000 Å) thick polysilicon layer is deposited and doped n-degenerate with $POCl_3$ in a well known manner to form the floating charge storage layer 4 of Fig. 1. The injector stack comprised of layers 3, 5, 1 of Fig. 1 consists of Chemically Vapour Deposited (CVD) silicon-rich silicon dioxide layers wherein layer 5 is silicon rich to a lesser extent than the layers 3, 1 of Fig. 1. The silicon richness of the layers is controlled during deposition by controlling the gaseous concentration ratio of $N_2O$ to $SiH_4$ in the CVD reactor. Thus, where the ratio is 100 for deposition of a layer of pure $SiO_2$, it is reduced to 50 to provide an $SiO_2$ layer which has a 1—3% excess of silicon in it. Thus, where stoichiometric $SiO_2$ has approximately 33 atomic % Si in it, the Si-rich $SiO_2$ having an excess of 1—3 atomic % Si in it would now contain 34—36 atomic percent Si.

In a preferred embodiment, injectors 1, 3 may be deposited by chemical vapour deposition in a range of thicknesses of 10—20 nm (100 Å—200 Å) and contain excess silicon in a range of 1—13 atomic percent. Layer 5 may be deposited in a thickness range of 15—60 nm (150 Å—600 Å) and contain excess silicon in a range of 1—6 atomic percent.

After deposition of injector 1, a 200 nm (2000 Å) thick polysilicon, n-degenerate layer similar to layer 4 is deposited and doped. In a succeeding step, plasma etching, reactive ion etching and wet etching are used to define source and drain. Source and drain are then diffused in a well known way and a 100 nm (1000 Å) thick oxide is regrown at 1000°C over the source and drain. A protective 300 nm (3000 Å) layer of CVD $SiO_2$ followed by a phosphosilicate glass (PSG) passivation are deposited and annealed at 1000°C. Finally, contact holes to the source drain and polysilicon gate 2 are defined and etched, followed by palladium silicide ($Pd_2Si$) and aluminum metallizations and a 400°C anneal for 20 minutes in forming gas (90% $N_2$-10% $H_2$).

CVD silicon-rich silicon dioxide layers 1, 3 are deposited at 700°C using a ratio of concentrations of $N_2O$ to $SiH_4$ in the gas phase of 3 and, under such conditions, contain 46% atomic silicon or 13% excess silicon over that found in pure $SiO_2$. From the foregoing, it should be clear that by simply adjusting the above mentioned ratio, the amount of silicon richness can be easily controlled.

An exemplary device fabricated using the above outlined process has a channel length of $2.5 \times 10^{-4}$ cm after photolithography, but effectively is about $1.8 \times 10^{-4}$ cm after diffusion drive in and subsequent high temperature processing. The channel width is $4.0 \times 10^{-4}$ cm and the FET channel area $7.2 \times 10^{-8}$ cm². The actual injecting area for writing and erasing can be smaller, for example, $2.5 \times 10^{-4}$ cm $\times 2 \times 10^{-4}$ cm $= 5 \times 10^{-8}$ cm².

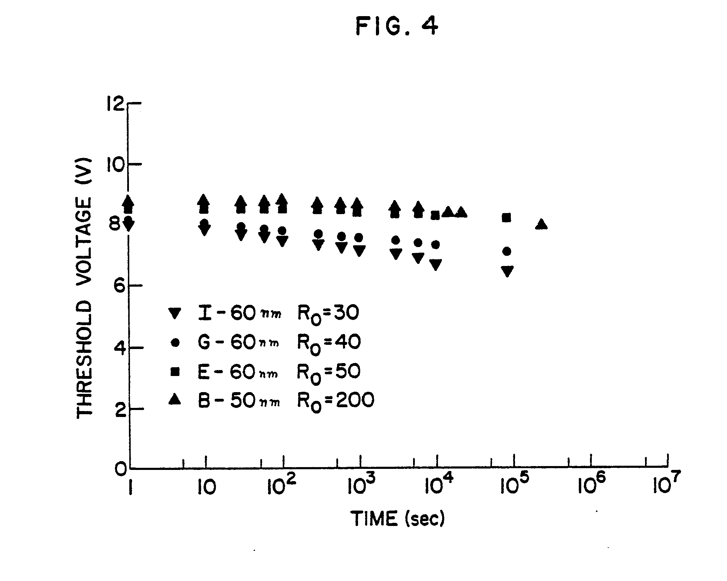

The FET DEIS structure of Fig. 1 is placed in the write or erase modes by using moderate gate voltages between −5 V and −40 V and +5 V and +40 V, respectively, on the control gate electrode 11, the exact voltage magnitude depending on device configuration. Other device configurations with three or more parts which use only positive voltages for either the write or erase operations have been discussed in the article entitled "Dual-Electron-Injector-Structure Electrically Alterable Read-Only-Memory Modeling Studies", by D. J. DiMaria et al, IEEE Transactions on Electron Devices, *ED-28*, pp. 1047—1053, 1981. Once floating gate 4 is charged positively or negatively, the device can be read with voltages between 0 to +5 V on control gate 2 and a small voltage applied between the source and drain 7. If the structure is in the erased or written state, current or no current will flow, respectively, in the FET channel between source 6 and drain 7. This structure has good charge retention either grounded or floating (at least for periods of one day at 25°C) as shown in Fig. 4, and thus serves as a non-volatile memory. It can be cycled approximately $10^6$ to $10^8$ times as opposed to prior art arrangements which could be cycled $10^3$ to $10^5$ times. As with the prior art, the threshold voltage window collapse is ultimately caused by trapped charge buildup in the CVD Si enriched $SiO_2$ region 5.

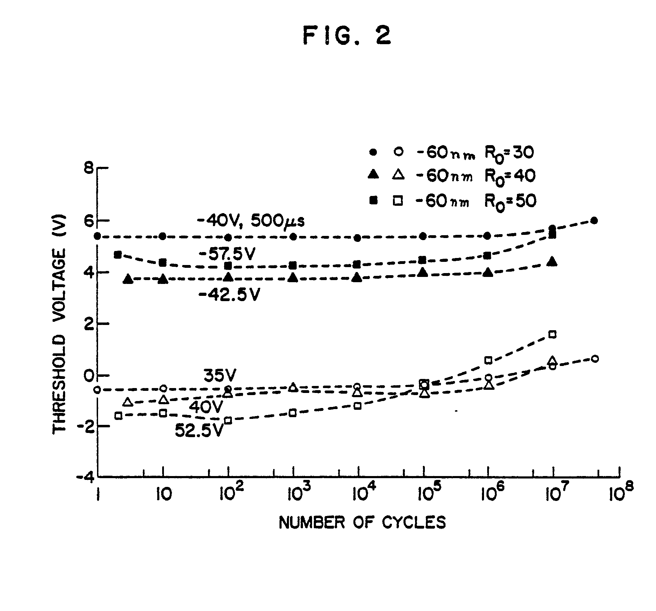

Referring now to Fig. 2 there is shown therein the variation in threshold voltage with the number of write and erase cycles for three different values of resistivity ($R_o$=50 being indicative of the most resistive intervening off-stoichiometry $SiO_2$ layer) of the layer 5 disposed between injectors or layers 1, 3. To obtain this data devices similar to that described hereinabove were utilized except that the region 5 was formed with different amounts of excess silicon. The region 5 in all instances was 60 nm (600 Å) thick while the resistivity values were 30, 40 and 50 signifying approximately 5—6% excess silicon, approximately 3—4% excess silicon and approximately 1—2% excess silicon, respectively. It should be noted that the onset of threshold collapse which is due to the storing of trapped charge in the region 5 does not begin until after at least $10^6$ cycles. Writing is performed by applying a negative voltage $V^{-g}$ to control gate 2 which injects electrons from the silicon-rich silicon dioxide injector layer 1 into the intervening oxide layer 5 which then flow in the electric field to the floating polysilicon gate 4. Erasing is performed by applying a positive voltage $V^{+g}$ to control gate 2 which injects electrons from the bottom silicon-rich silicon dioxide injector 3 back to control gate 2. The negative and positive voltages shown with the curves are those utilized for writing and erasing, respectively. In all instances, the voltages were applied for 500 microseconds. The introduction of silicon to render the normally insulating layer 5 slightly conductive does not prevent ultimate threshold voltage collapse. This expedient, however, does extend the ability to cycle beyond $10^{10}$ cycles before complete threshold voltage collapse occurs. One explanation is that the probability of capture of electrons in layer 5 becomes more and more likely as the device is cycled between its write and erase function.

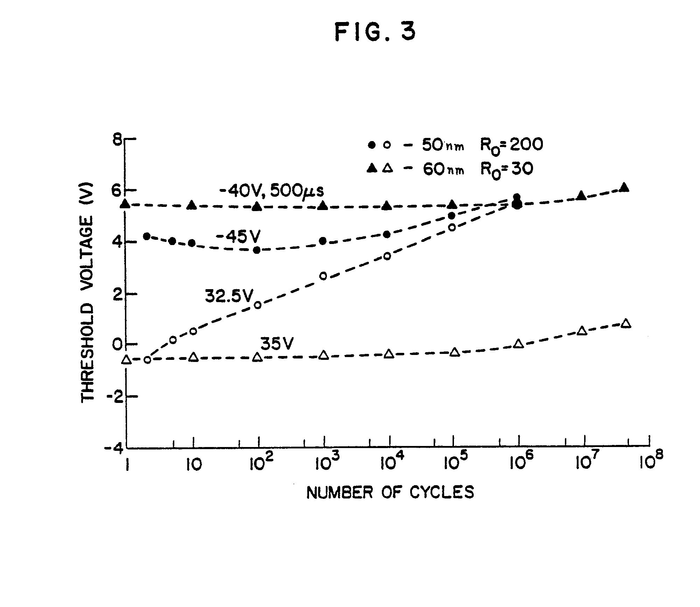

Fig. 3 is a graph similar to that shown in Fig. 2 which shows that for a high value of $R_o$ equal to 200 which represents pure silicon dioxide, total threshold collapse occurs before $10^6$ cycles while for a lower value of $R_o$ equal to 30, threshold collapse does not occur until after $10^7$ cycles.

Fig. 4 is a graph of threshold voltage variation with time for devices with regions 5 of Fig. 1 having $R_o$ values of 30, 40, 50, and 200. This graph shows that for relatively high values of resistivity (for example, $R_o$ equal to 50), electron leakage from a floating gate to a control gate is approximately the same as the leakage for a pure $SiO_2$ insulator ($R_o$=200).

The use of a slightly conductive region between silicon-rich silicon dioxide injectors enhances the ability to cycle a device between its write and erase modes. To the extent that lower writing and erasing voltages result from the use of a slightly conductive region, power dissipation in such devices is decreased. In addition, the voltages utilized to write and erase become approximately the same value. While the above improvements come about as a result of adding more silicon to the silicon dioxide insulator, it should be appreciated that retention of charge is only slightly degraded.

The distribution of the conductive material in regions 1, 3, 5 is not critical. The conductive material may be uniformly or nonuniformly distributed in these regions. Each region may be formed of a plurality of layers each having a different concentration of conductive material so that the concentration is graded from one interface to another interface.

Also, it should be appreciated that, while there has just been described an application of the invention to an n-channel FET, the invention may also be applied to p-channel FET's.

While the materials silicon and silicon dioxide are the preferred materials, it should be appreciated that other insulating materials such as aluminum oxide and silicon nitride and practically any metal or semi-metal including silver, gold, tantalum, silicon and aluminum metals, may also be utilized in the practice of the present invention. The insulator may be deposited together with metal which renders the insulator conductive or a metallic species may be added to the insulator by diffusion or ion implantation after the insulator is formed. The slightly conductive insulator is designed so that it is conductive only at high electric fields encountered during writing and erasing and highly blocking at low fields encountered during reading or storage operations. Obviously, insulating materials and metals which are compatible with each other and with semiconductor processing techniques will find wider use than other material combinations which do not lend themselves so readily to semiconductor processing.

### Claims

1. A dual electron injector structure comprising first, second and third regions (1, 5, 3), the first region (1) being disposed on top of the second region (5) and the second region (5) on top of the third region (3), the second region (5) having a higher resistance than that of the first and third regions and the first and third regions (1, 3) consisting of a mixture of insulating and conductive materials, the structure being characterised in that the second region (5) is slightly conductive and consists of a mixture of insulating and conductive materials such that it is conductive only at high electric fields and highly blocking at low electric fields.

2. A structure as claimed in claim 1, in which the conductive material in the first, second and third regions is metallic material.

3. A structure as claimed in claim 1, in which the conductive material comprised in the first, second and third regions is semimetallic material.

4. A structure as claimed in claim 3, in which the conductive material in the first, second and third regions is silicon.

5. A structure as claimed in claim 4, in which the insulating material in the first, second and third regions is silicon dioxide and the first and third regions contain up to 25% excess silicon over that found in stoichiometric silicon dioxide and wherein the second region contains up to 6% excess silicon over that found in the stoichiometric silicon dioxide.

6. A structure as claimed in any preceding claim, in which there is a uniform distribution of the conductive material in each of the first, second and third regions.

7. A structure as claimed in any of claims 1 to 5, in which there is a non-uniform distribution of the conductive material in each of the first, second and third regions.

8. A structure as claimed in any of claims 1 to 4, 6 and 7, in which the insulating material in the first, second and third regions is silicon dioxide, silicon nitride or aluminium oxide.

9. A structure as claimed in any preceding claim, further including first and second conductors contiguous with said first and third regions respectively.

10. A semiconductor memory device comprising a semiconductor substrate (8) of one conductivity type having a pair of regions (6, 7) of opposite conductivity type disposed therein and forming a channel region therebetween; an insulating layer (12) formed over said channel region, a floating gate electrode (4) formed over said insulating layer (12); a dual electron injector structure (1, 5, 3) formed over said floating gate electrode (4), and a gate electrode (2) disposed over said dual electron injector structure, characterised in that the dual electron injector structure is as claimed in any preceding claim.

**Patentansprüche**

1. Doppelelektroneninjektoraufbau mit einem ersten, zweiten und dritten Bereich (1, 5, 3), wobei der erste Bereich (1) oben auf dem zweiten Bereich (5) und der zweite Bereich (5) oben auf dem dritten Bereich (3) angeordnet ist, der zweite Bereich (5) einen höheren Widerstand als der erste und dritte Bereich hat, und der erste und dritte Bereich (1, 3) aus einem Gemisch aus isolierendem und leitfähigem Material bestehen, wobei der Aufbau dadurch gekennzeichnet ist, daß der zweite Bereich (5) schwach leitend ist und aus einem Gemisch aus isolierendem und leitfähigem Material derart besteht, daß er nur bei starken elektrischen Feldern leitend und bei schwachen elektrischen Feldern stark sperrend ist.

2. Aufbau nach Anspruch 1, bei welchem das leitfähige Material im ersten, zweiten und dritten Bereich metallisches Material ist.

3. Aufbau nach Anspruch 1, bei welchem das im ersten, zweiten und dritten Bereich enthaltene leitfähige Material halbmetallisches Material ist.

4. Aufbau nach Anspruch 3, bei welchem das leitfähige Material im ersten, zweiten und dritten Bereich Silizium ist.

5. Aufbau nach Anspruch 4, bei welchem das isolierende Material im ersten, zweiten und dritten Bereich Siliziumdioxid ist und der erste und dritte Bereich bis zu 25% Überschuß an Silizium gegenüber dem enthalten, was sich in stöchiometrischem Siliziumdioxid findet, und bei welchem der zweite Bereich bis zu 6% Überschuß an Silizium gegenüber dem enthält, was sich im stöchiometrischen Siliziumdioxid findet.

6. Aufbau nach irgendeinem vorstehenden Anspruch, bei welchem eine gleichförmige Verteilung des leitfähigen Materials in jedem des ersten, zweiten und dritten Bereichs vorliegt.

7. Aufbau nach irgendeinem der Ansprüche 1 bis 5, bei welchem eine nicht-gleichförmige Verteilung des leitfähigen Materials in jedem des ersten, zweiten und dritten Bereichs vorliegt.

8. Aufbau nach irgendeinem der Ansprüche 1 bis 4, 6 und 7, bei welchem das isolierende Material im ersten, zweiten und dritten Bereich Siliziumdioxid, Siliziumnitrid oder Aluminiumoxid ist.

9. Aufbau nach irgendeinem vorstehenden Anspruch, welcher ferner einen ersten und zweiten Leiter enthält, die an den ersten bzw. dritten Bereich angrenzen.

10. Halbleiterspeichervorrichtung mit einem Halbleitersubstrat (8) des einen Leitungstyps, in welchem ein Paar von Bereichen (6, 7) entgegengesetzten Leitungstyps angeordnet ist und einen Kanalbereich dazwischen ausbildet; einer isolierenden Schicht (12), welche über dem Kanalbereich ausgebildet ist, einer schwebenden Gate-Elektrode (4), welche über der isolierenden Schicht (12) ausgebildet ist; einem Doppelelektroneninjektoraufbau (1, 5, 3), welcher über der schwebenden Gate-Elektrode (4) ausgebildet ist, und einer Gate-Elektrode (2), welche über dem Doppelelektroneninjektoraufbau angeordnet ist, dadurch gekennzeichnet, daß der Doppelelektroneninjektoraufbau einer nach irgendeinem vorstehenden Anspruch ist.

## Revendications

1. Structure à deux injecteurs d'électrons comportant une première, une seconde et une troisième régions (1, 5, 3), la première région (1) étant disposée sur le dessus de la seconde région (5) et la seconde région (5) sur le dessus de la troisième région (3), la seconde région (5) ayant une résistance plus élevée que celle de la première et la troisième régions et la première et la troisième régions (1, 3) consistant en un mélange de matières isolantes et conductrices, la structure étant caractérisée en ce que la seconde région (5) est légèrement conductrice et consiste en un mélange de matières conductrices et isolantes de manière qu'elles ne soient conductrices que sous des champs électriques élevés et hautement bloquantes sous des champs électriques faibles.

2. Structure selon la revendication 1, dans laquelle la matière conductrice dans la première, la seconde et la troisième régions est une matière métallique.

3. Structure selon la revendication 1, dans laquelle la matière conductrice qui constitue la première, la seconde et la troisième régions est une matière semi-métallique.

4. Structure selon la revendication 3, dans laquelle la matière conductrice dans la première, la seconde et la troisième régions est du silicium.

5. Structure selon la revendication 4, dans laquelle la matière isolante dans la première, la seconde et la troisième régions est du bioxyde de silicium et la première et la troisième régions contiennent jusqù à 25% de silicium en excès par rapport à celui qui se trouve dans du bioxyde de silicium stoéchiométrique et dans laquelle la seconde région contient jusqu'à 6% de silicium en excès par rapport à celui qui se trouve dans le bioxyde de silicium stoéchiométrique.

6. Structure selon l'une quelconque des revendications précédentes, dans laquelle il existe une distribution uniforme de matière conductrice dans chacune de la première, la seconde et la troisième régions.

7. Structure selon l'une quelconque des revendications 1 à 5, dans laquelle il existe une distribution non uniforme de la matière conductrice dans chacune de la première, la seconde et la troisième régions.

8. Structure selon l'une quelconque des revendications 1 à 4, 6 et 7, dans laquelle la matière isolante dans la première, la seconde et la troisième régions est du bioxyde de silicium, du nitrure de silicium ou de l'oxyde d'aluminium.

9. Structure selon l'une quelconque des revendications précédentes, comportant en outre un premier et un second conducteurs contigüs respectivement de la première et de la troisième régions.

10. Mémoire à semi-conducteur comportant un substrat semi-conducteur (8) d'un type de conductivité, comprenant une paire de régions (6, 7) de type de conductivité opposé qui y sont disposées et formant une région de canal entre elles; une couche isolante (12) formée sur ladite région de canal, une électrode de grille flottante (4) formée sur ladite couche isolante (12); une structure à deux injecteurs d'électrons (1, 5, 3) formée sur ladite électrode de grille flottante (4) et une électrode de grille (2) disposée sur ladite structure à deux injecteurs d'électrons, caractérisée en ce que la structure à deux injecteurs d'électrons est telle que revendiquée dans l'une quelconque des revendications précédentes.

# FIG. 1

SOURCE      GATE      DRAIN

$V_S$      $V_g$      $V_D$

11

$e^-$ INJECTOR FOR $V_g^-$

2

$SiO_2$    1    5    $SiO_2$

3

4

9    $SiO_2$    $e^-$ INJECTOR FOR $V_g^+$    10

12

$n^+$    6    7    $n^+$

$p^-$ Si

8

# FIG. 2

# FIG. 3

FIG. 4